# EUROPEAN PATENT APPLICATION

(11) **EP 0 980 002 A1**
(43) Date of publication of application: **16.02.2000**
(21) Application number: 99113736.5
(22) Date of filing: 13.07.1999
(51) Int. Cl.: G01R 11/24

(54) **A device for detecting and reporting theft of electric power**

(30) Priority: 13.07.1998 IL 12532798
(71) Applicant: Powercom Control Systems Ltd., Givat Shmuel 51905 (IL)
(72) Inventor: Shraga, Pesach, Givatayim 53255 (IL); Notkin, Jury, Givat Shmuel 54021 (IL)
(74) Representative: VOSSIUS & PARTNER

(57) **Abstract**

The invention relates to:
A device for detecting and reporting theft of electric power resulting from the disconnection of or tampering with an electricity meter fitted with a remote communication device connected to an automatic meter reading system, and having a disk rotating in a fixed direction at a speed proportional to the power consumed in a customer circuit being metered, said system comprising a) an optical sub-system arranged to detect speed and direction of rotation of the meter disk and generating corresponding electrical output signals; and b) a microcontroller programmed to receive said signals, and for recording signals indicating a stopped, braked or reversing meter disk resulting from tampering with or removal of said electricity meter, and reporting the type of suspected tampering and the identification of said meter to said automatic meter reading system through said remote communication device.

## Description

The present invention relates to a device for combating theft of electric power. More particularly, the invention includes an electro-optical device which detects abnormalities in the rotation or lack thereof of the disk in a watt-hour meter, recognizes and classifies such irregularity as to the type of meter tampering causing such abnormality, and reports the type of tampering detected via a remote communication device.

The American Edison Institute estimates that the theft of electric power resulting from meter tampering is between 2 - 3% of power supplied. Utilities in South America and in South Africa estimate such losses at between 10 - 15%. As possibly billions of dollars are thus lost to the supply utilities yearly, there is economic justification for reducing such losses by taking appropriate counter measures.

Recent years have seen an increasing widespread installation of systems for Automatic Meter Reading (AMR), such systems using telephone lines, radio, or power lines as part of the remote communication system, while retaining the ready-installed watt-hour meter. The AMR system will detect negative electricity "consumption^{"}, and may in some cases also detect a temporary communication break, but AMR as used presently will fail to identify theft resulting from types of tampering which cause registration of consumption less than that actually used by the consumer. It will be recognized that recorded very low consumption does not in itself indicate meter tampering, as the premises being metered may be temporarily unoccupied.

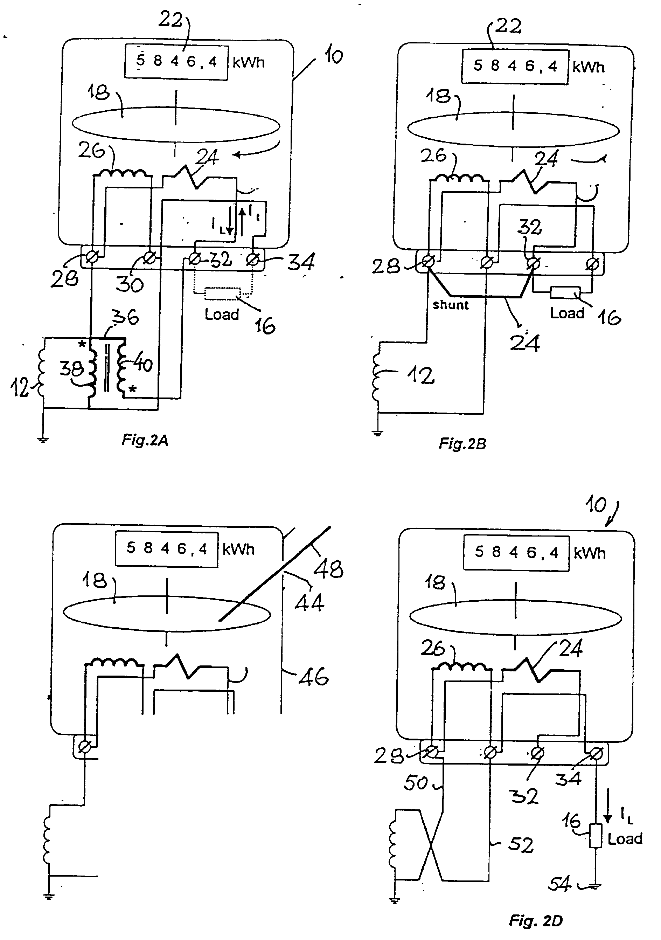

Nevertheless AMR provides a tool which is utilized for reporting theft by the device of the present invention.
Theft methods reported by the Automatic Meter Reading Association and other surveys are numerous. The more common types of illegal tampering known for carrying out such theft are:
1. Meter substitution
2. Turning back the meter pointers
3. Filing down the first register gear
4. Changing meter adjustments
5. Opening the potential link
6. Inserting a resistor in series in the potential link
7. Inserting a photo cell in series in the potential link
8. Causing disk reversal by inverting connections to the meter coils
9. Drilling a hole in the meter cover and inserting an object to stop or slow the disk rotation, as shown in FIG. 2c.
10. Inserting a jumper in the meter socket, shown In FIG. 2b
11. Adding an external transformer to effect disk rotation reversal, see FIG. 2a
12. Bypassing a part of the meter by use of a phase-to-ground connection, as in FIG.2d.

Methods 1 - 8 require either removal of the meter or removal of the meter cover, the latter being detectable by breakage of the meter seal.
Method 9 is more difficult to detect. In one variation of this method a sweet powder or liquid is poured into the drilled hole, which then attracts insects which enter the meter and slow down or stop the rotating disk.
Methods 10 - 12 are even more difficult to detect as they can be effected without leaving evidence after their subsequent removal. Thus, unless left in place and discovered by an alert human meter reader, these methods may escape detection.

In US Patent no. 3,765,008 Lowry discloses an apparatus for the detection of theft of electrically operated articles, for example television sets from a motel. The device sends power to an alarm system upon detection of unplugging or cutting of the power supply cord. Such device would be of only limited benefit for use on electric meters as it would fail to detect any theft of electricity carried out while the meter remains connected.

There have been previous proposals aimed at detecting electricity theft or punishing such attempt by arranging for the meter to run faster thereafter.
Venaas et al, in US Patent no. 4,386,313 describe and claim an electricity meter having one of its bayonets slidably mounted on the meter base. Removal of the meter and its reinsertion after illegal electricity consumption causes a change in the connection to the disk drive coil, causing the meter to run fast thereafter. The device is thus limited to discouraging meter removal, but will do nothing to detect types of tampering leaving the meter in place.

Furthermore, this device is inapplicable to meters connected to the supply by screw terminals. It is also far from certain that this form of punishment meted out by the electricity supplier would withstand legal challenge in court.

US Patents 4,327,324 to Weltz and no. 4,514,683 to Deibert et al provide means for detecting and stopping reverse direction rotation of the meter disk. These devices do not respond to tampering resulting in a stopped or in a braked disk. Furthermore, while these devices can be used on newly designed meters, they are unsuitable for retrofitting millions of existing meters.

Prior art devices are not provided with communication means to immediately report meter tampering, so the detectable signs thereof can be removed by a dishonest consumer before routine inspection by an employee of the electricity supplier. Also, no prior art system has global application to cover all known methods of electricity theft.

An advantage of AMR is that lack of communication, such as occurs during meter removal or exchange, or as may occur during tampering with the remote communication system is in itself an alarm condition, although it does not necessarily indicate tampering. For example, meter removal to cut off the electricity may be done legally in response to the breakout of a fire in the metered premises, and so does not as such prove an attempt at electricity theft.

It is therefore one of the objects of the present invention to obviate the disadvantages or prior art electricity theft detection devices and to provide a device which will detect and report any known type of tampering with the electricity meter, including disk braking, reversal, stoppage, changes in meter connections such as bypassing, reversing, addition of electric components to the meter terminals, and of course temporary or permanent meter removal.
It is a further object of the present invention to record and store data relating to detected meter tampering.
The present invention achieves the above objects by providing a device for detecting and reporting theft of electric power resulting from the disconnection of or tampering with an electricity meter fitted with a remote communication device connected to an automatic meter reading system, and having a disk rotating in a fixed direction at a speed in proportion to the power consumed in a customer circuit being metered. The system includes
a) an optical sub-system arranged to detect speed and direction of rotation of the meter disk and generating corresponding electrical output signals; and
b) a microcontroller programmed to receive said signals, and for recording signals indicating a stopped, braked or reversing meter disk resulting from tampering with said electricity meter, and reporting the type of fault and the identification of said meter through said remote communication device.

In a preferred embodiment of the present invention there is provided a device wherein said optical system comprises at least one marked section of said disk, a light source directed towards said marked section, two light detectors directed toward said disk each light detector generating an electric signal pulse in response to passage of said marked section in its proximity.

In a most preferred embodiment of the present invention there is provided a device wherein a reference electric current is periodically sent through the coils driving said disk, and the resulting increased speed of said disk is measured by said optical sub-system and compared by said microcontroller with a prerecorded record of correct speed increase for such current increase. A shortfall in such speed increase is recorded and a braked disk message is sent to said remote communication device.

Yet further embodiments of the invention will be described hereinafter.

It will thus be realized that the novel device of the present invention serves to detect, record and report soon after detection any tampering with the meter. Types of tampering detected include:
a) removal, disconnection or exchange of the meter;
b) braking of the meter disk by mechanical, electrical or any other means; and
c) reverse rotation of the meter disk however caused.

The device of the present invention can be retrofitted on existing meters of which huge quantifies are already installed. Obviously the device can even more conveniently be incorporated in the design of new meters which would be manufactured to be completely compatible to existing installations for easy replacement of existing meters.
The communication link used for AMR is used by, but is not part of the device of the present invention.

The invention will now be described further with reference to the accompanying drawings, which represent by example preferred embodiments of the invention. Structural details are shown only as far as necessary for a fundamental understanding thereof. The described examples, together with the drawings, will make apparent to those skilled in the art how further forms of the invention may be realized.

In the drawings:
FIG. 1 is a diagrammatic view of a prior art electric meter, connected to an AMR, the meter being wired correctly as installed by the electricity supply utility;
FIG. 2a is a diagrammatic view of a meter where a transformer has been added in an attempt at electricity theft by slowing, stopping or reversing the metering disk;
FIG. 2b is a diagrammatic view of a meter where a shunt has been added in an attempt at electricity theft by slowing the metering disk;
FIG. 2c is a diagrammatic view of a meter where a hole has been drilled in the meter casing and a foreign body inserted in an attempt at electricity theft by slowing or stopping the metering disk;
FIG. 2d is a diagrammatic view of a meter where connections to the meter have been reversed, and the consumer load wired to earth to by-pass part of the meter in an attempt at electricity theft by slowing the metering disk;
FIG. 3 is a diagrammatic view of an electric meter preferred embodiment according to the invention which detects disk stoppage and disk direction reversal;
FIG. 4a is a diagrammatic view at an embodiment of the electro-optics for detecting disk revolution and irregularities thereof;
FIG. 4b represents pulses produced by the electro-optics shown in FIG. 4a which allow detection of reverse direction, logic signals being shown for correct and for reverse direction rotation of the disk;
FIG. 5 is a block diagram of an embodiment provided with an independent power supply;
FIG. 6a is a diagrammatic view of a meter according to the present invention which detects disk braking as well as disk stopping;
FIG. 6b is a block diagram of a logic system suitable for use in the embodiment seen in FIG. 6a;
FIG. 7a is a diagrammatic view of an embodiment including a transformer-like device and comparator used to detect illegal meter bypassing; and
FIG. 7b is a block diagram including said comparator.

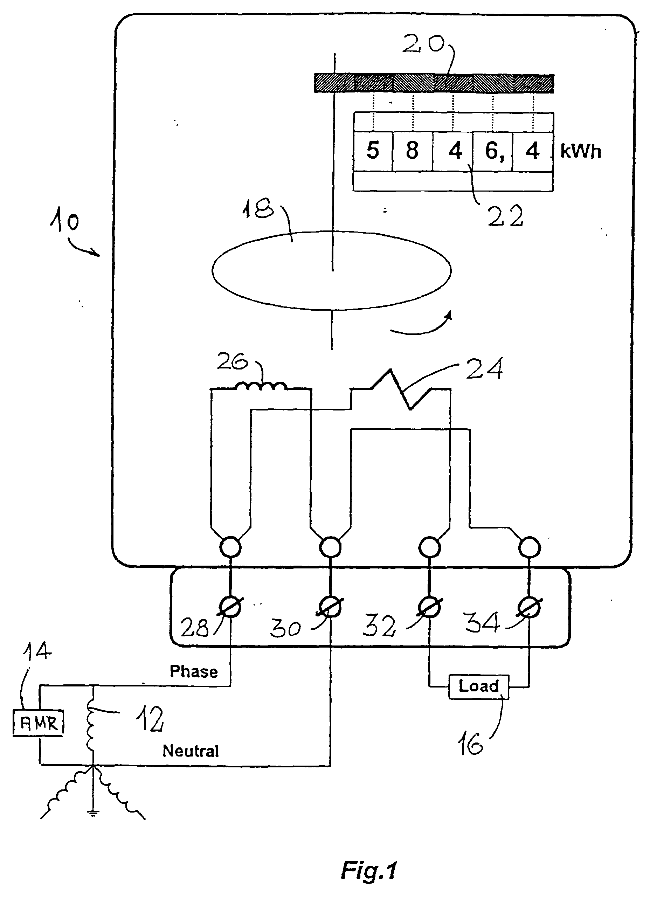

There is seen in FIG. 1 a prior-art watt-hour electric meter 10, used for AC single phase 12, and connected to an AMR (Automatic Meter Reading) device 14.
The meter 10 is shown connected to a consumer load 16 in its correct, legal configuration as installed by the electricity supply utility.
A metering disk 18 drives a set of gears 20 which drive the mechanical register 22 recording consumption.
The disk 18 is driven to rotate, in a fixed direction by electric currents which flow in both the current coil 24, which has a very low resistance, and a voltage coil 26 which has a high resistance. Both currents produce an electric field which interacts with a field induced in the disk 18, resulting in disk revolution in proportion to consumed power.
Tampering with the prior-art meter 10 is detected only in the following three modes:
a. The meter 10 is disconnected, this will be detected by a communication break to the AMR 14.
b. Disk direction has been reversed to the extents showing negative consumption.
c. A visiting inspector finds a broken enclosure seal (not shown) or discovers illegal changes to the terminals 28, 30, 32, 34.

With reference to the rest of the figures, similar reference numerals have been used to identify similar parts.

Referring now to FIG. 2a there is seen a meter 10 which has been illegally connected to an added external transformer 36 in an attempt at electricity theft by slowing, stopping or reversing the metering disk 18. The transformer primary winding 38 is connected to meter terminals 28 and 30. The secondary coil 40 is connected to meters terminals 28 and 32. A current, lₜ now flows to terminal 30, in opposed direction to the load current lₜ. Speed and direction of rotation of the disk 18 now depends on the difference between these two currents.

FIG. 2b shows a meter where a shunt 42 has been illegally added between terminals 28 and 32 in an attempt at electricity theft by slowing the metering disk 18. The shunt 42 draws off some of the current which would otherwise flow through the current coil 24. Electric connections are identical to those described with reference to FIG. 1.

Drilling a hole 44 in the meter casing 46 and inserting a foreign object 48 to stop or slow the disk 18 rotation is shown in FIG. 2c. Such tampering can be effected without breaking the meter enclosure seal (not shown). A 2 mm hole 44 is easily overlooked by a visiting inspector, unless he is specially alerted to search therefor.

In FIG. 2d there is seen a meter 10 where phase to ground connections 50, 52 to the meter have been reversed, and the consumer load 16 is wired to earth 54 to by-pass a part of the meter 10 in an attempt at electricity theft by slowing the metering disk 18. The current coil 24 is thus disconnected, as there is no connection to terminal 32, leaving only the voltage cell 24 to drive the meter disk 18.

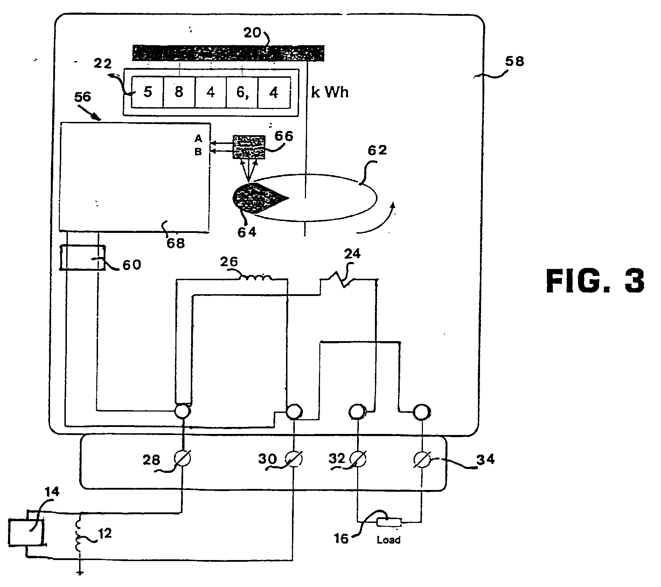

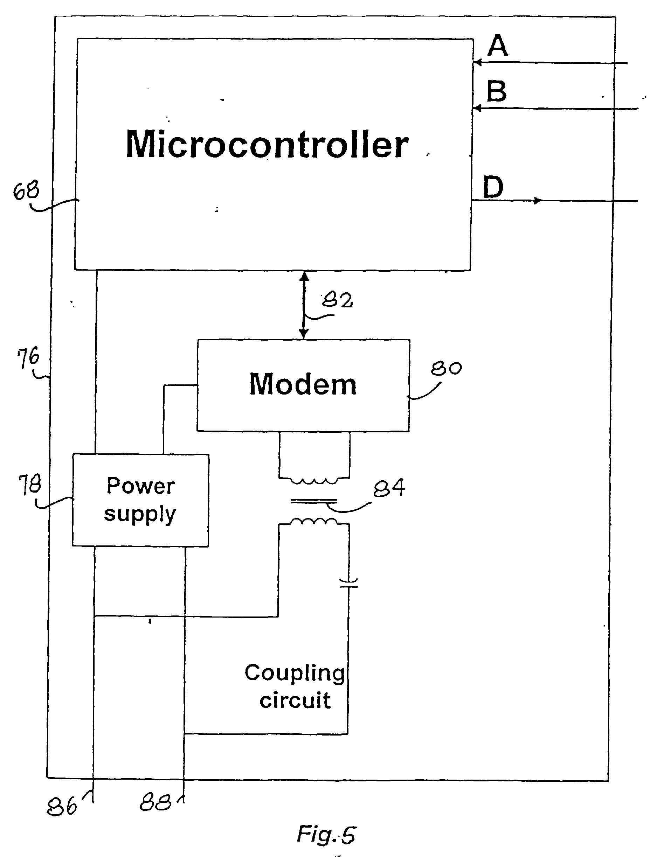

FIG. 3 illustrates a first embodiment of a device 56 according to the present invention for detecting and reporting theft of electric power resulting from the disconnection of or tampering with an electricity meter 58 fitted with a remote communication device 60 connected to an automatic meter reading 14 system. An embodiment of device 60 will be described with reference to FIG. 5. The meter 58 has a meter disk 62 rotating in a fixed direction at a speed proportional to the power consumed in a customer circuit load 16 being metered. A machine-readable mark 64 is placed on the disk 62. An optical sub-system 66 is arranged to read passage of mark 64. A preferred embodiment of an optical sub system 66 will be described with reference to FIG. 4a. The sub-system 66 detects speed and direction of rotation of the disk 62, and generates corresponding electrical output signals. These signals are transferred to a microcontroller 68 programmed to receive said signals. The microcontroller 68 records signals indicating a stopped, braked or reversing meter disk 62 resulting from tampering with, or removal of, the electricity meter 58, and reports the type of suspected tampering and the identification of the meter to an automatic meter reading 14 system through a remote communication device 60.
Advantageously microcontroller 68 records in its non-volatile memory date and time of test results indicating tampering and sends also this data to the remote communication device 60.

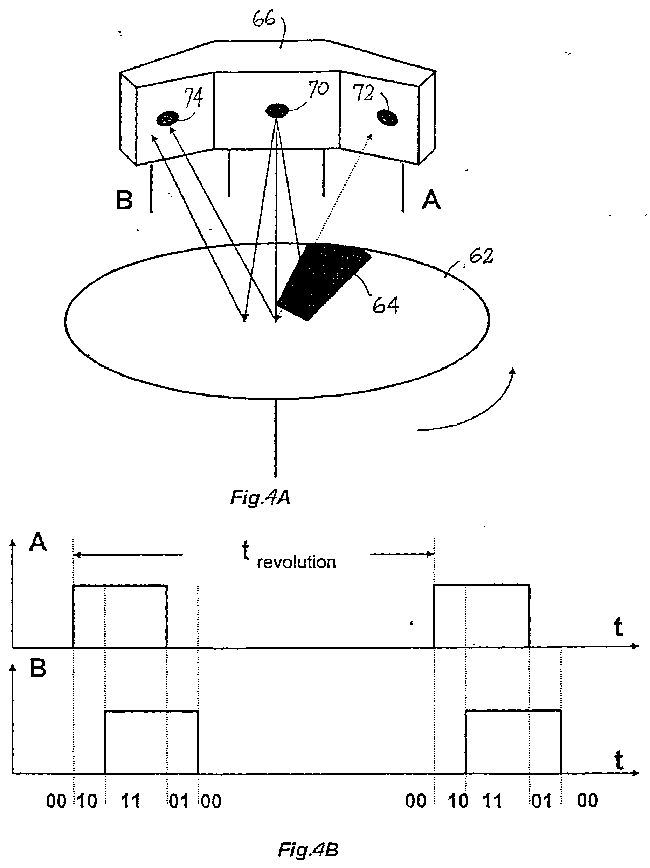

Seen in FIG. 4a is an embodiment of an optical sub-system 66. A marked section 64 of the meter disk 62 is illuminated by a light source 70 directed towards the marked section 64. Two light detectors, detector A 72, and detector B 74 are directed toward the disk 62, each light detector generating an electric signal pulse in response to passage of the marked section 64 in its proximity.
In the present embodiment detectors 72, 74 generate a low logic level when receiving light, and a high level in its absence.
The upper diagram in FIG. 4b shows the output from detector A 72, and the lower diagram from detector B 74. The logic sequence shown on the diagram is a resulting combination which will be generated if the disk 62 is revolving in its correct direction.
Should the disk 62 revolve in the reverse direction, the logic sequence will change to 00 01 11 10 00. The microcontroller 68 recognizes this change and then records in its non-volatile memory IUD (Illegal Use Detection) and will transmit this information to the automatic meter reading 14 system through the remote communication device 60.
It is to be noted that detection occurs irrespective of the method used to illegally cause the meter disk to revolve in a reverse direction.

Referring now to FIG. 5, there is depicted a further embodiment of the device 76 further comprising a power source 78 available to the consumer. The power source 78 is used for operation of the remote communication device 60 seen in FIG. 3, which in the present embodiment is a modem 80. Thus the modem 80 functions whether the meter is connected or has been illegally disconnected from the main electric power supply.
The modem 80 uses the power source 78 to receive and transmit information; and to exchange information with the microcontroller 68 through an interface 82. The modem 80 receives spread spectrum signals from the coupling circuit 84 and transforms these into digital data intelligible to the microcontroller 68.
In an embodiment the device comprises an independent power supply.
A suitable form of independent power supply includes a rechargeable electric battery which receives power while connected to the mains through leads 86, 88, and continues to supply power until exhausted even when disconnected as result of meter tampering.

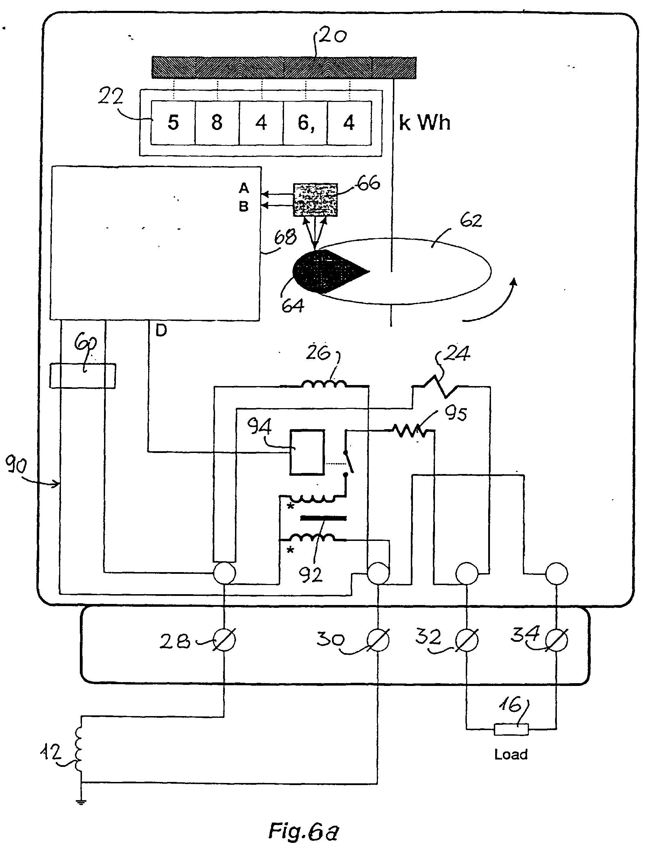

FIG. 6a shows an embodiment of the device 90 wherein a reference electric current is periodically added to the normal power used by the consumer. The additional power comes from a transformer 92, and causes an increased current to flow through the current coil 24 when a relay 94 switches on for purposes of a test, usually carried out for 2 - 3 minutes. A current limiting resistor is shown in series with the coil 24. The resulting increased speed of the disk 62, or lack thereof, is measured by the optical sub-system 66 and is compared by the microcontroller 68 with a prerecorded record of correct speed increase for such current increase. A shortfall in such speed increase is recorded by the microcontroller 68, which then sends a braked disk message to the remote communication device 60. If a correct speed increase is found, the microcontroller 68 records that illegal use has been checked for but was not detected and stops the test.

In a first embodiment, a testing procedure for tampering is intermittently initiated by the microcontroller 68 and the time length of the test is executed for a pre-selected time period.
In a second embodiment, a testing procedure is initiated as result of a signal sent by the electricity supply utility and received by the device 90 through the remote communication device 60.
The recommended test period depends on the type of meter used.

FIG. 6b shows a suitable logic system which can be used in the device of FIG. 6a.
Symbols used are explained below:
- tₒ: = test starting time
- tₓ: = time for one disk revolution, unknown load power
- t₁: = moment interrupt received
- t₂: = later moment interrupt received
- t₃: = yet later moment interrupt received
- t_{L}: = time for one disk revolution, load power
- t_{Lr}: = time for one disk revolution, reference + load power
- t_{L1}: = expected time of disk revolution
- t _{L2}: = measured time at disk revolution
- tᵣ: = time for one disk revolution under reference power
- n: = integer
- IU: = illegal use
- δ: = accepted reference power (voltage variation) tolerance

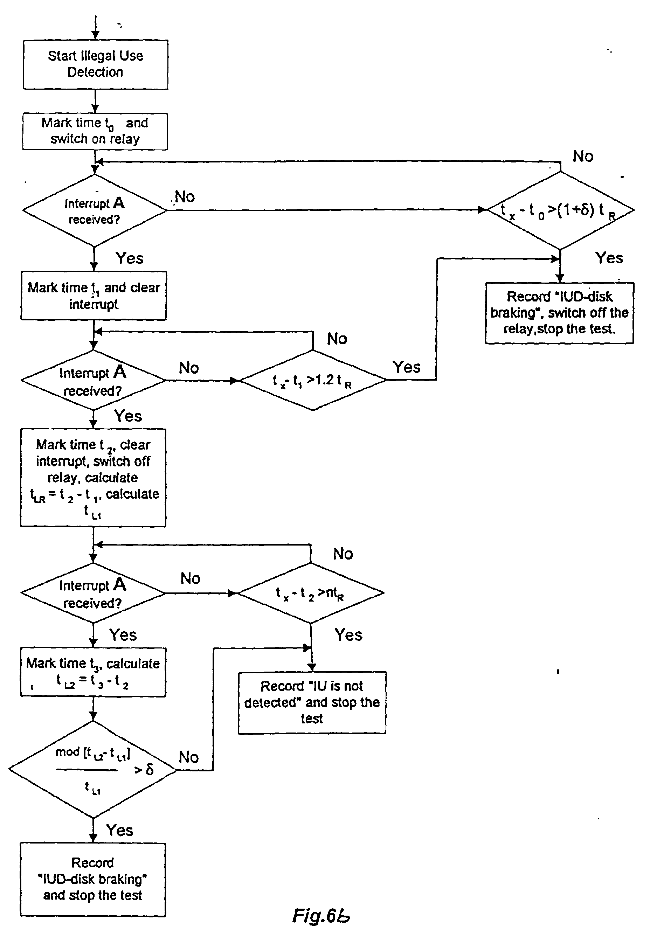

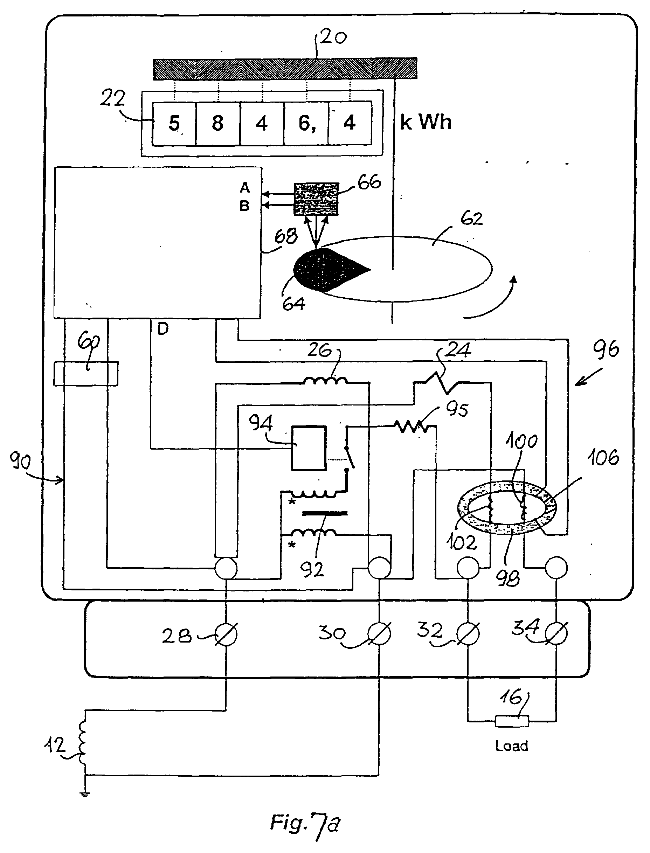

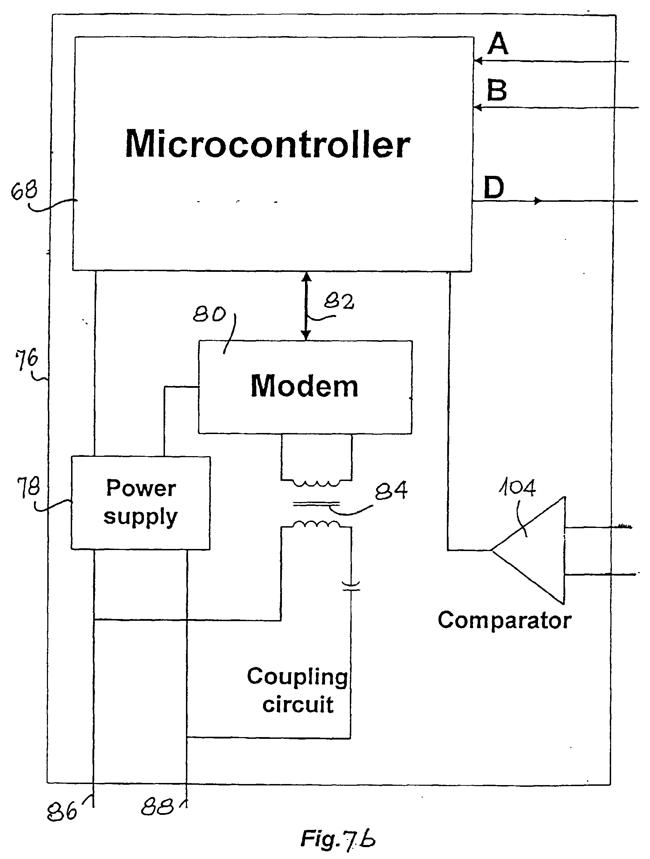

FIGS. 7a & 7b illustrate an embodiment of a device 96 detecting meter bypassing. The device 96 includes a transformer-like device 98 wherein the consumer load 16 current flows through a first winding 100 and the current coil 24 current flows through the second winding 102. The two windings are constructed to be balanced, each producing an equal but opposite magnetic field resulting in substantially zero detectable magnetic flux therebetween under normal legal usage.
However when the meter is at least partially bypassed, the second winding 102 receives less or no current, and magnetic field is produced by the first winding 100 is no longer balanced out and a detectable flux is received by a comparator 104 from a coil 106. The comparator 104 generates a signal which is sent to the microcontroller 68, which activates a message announcing illegal bypassing of the meter.

The scope of the described invention is intended to include all embodiments coming within the meaning of the following claims. The foregoing examples illustrate useful forms of the invention, but are not to be considered as limiting its scope, as those skilled in the art will readily be aware that additional variants and modifications of the invention can be formulated without departing from the meaning of the following claims.

## Claims

1. A device for detecting and reporting theft of electric power resulting from the disconnection of or tampering with an electricity meter fitted with a remote communication device connected to an automatic meter reading system, and having a disk rotating in a fixed direction at a speed proportional to the power consumed in a customer circuit being metered, said system comprising
a) an optical sub-system arranged to detect speed and direction of rotation of the meter disk and generating corresponding electrical output signals; and
b) a microcontroller programmed to receive said signals, and for recording signals indicating a stopped, braked or reversing meter disk resulting from tampering with or removal of said electricity meter, and reporting the type of suspected tampering and the identification of said meter to said automatic meter reading system through said remote communication device.

2. The device as claimed in claim 1, further comprising a power source, for operation of said remote communication device.

3. The device as claimed in claim 1, wherein said optical system comprises at least one marked section of said disk, a light source directed towards said marked section, two light detectors directed toward said disk each light detector generating an electric signal pulse in response to passage of said marked section in its proximity.

4. The device as claimed in 1, wherein a testing procedure for tampering is intermittently initiated by said microcontroller and the the length of the test is executed for a pre-selected time period.

5. The device as claimed in claim 1, wherein a testing procedure is initiated as result of a signal received by said system through said remote communication device.

6. The device as claimed in claim 1, wherein said microcontroller records test results indicating tampering in its non-volatile memory and ceases further testing after sending said results to said remote communication device.

7. The device as claimed in claim 1, wherein said microcontroller records in its non-volatile memory date and time of test results indicating tampering and also sends this data to said remote communication device.

8. The device as claimed in claim 1, wherein a reference electric current is periodically sent through the coils driving said disk, the resulting increased speed of said disk or lack thereof is measured by said optical sub-system and is compared by said microcontroller with a prerecorded record of correct speed increase for such current increase, a shortfall in such speed increase being recorded and a braked disk message being sent to said remote communication device.

9. The device as claimed in claim 1, further comprising a transformer-like device wherein consumer load current flows through a first transformer winding and disk coil current flows through the second transformer winding, said windings being balanced to produce substantially zero detectable magnetic flux under normal usage, but producing a detectable flux when said meter is at least partially bypassed, said detectable flux being received by a comparator which generates a signal sent to said microcontroller for activating a message announcing illegal bypassing of said meter.
